# EUROPEAN PATENT APPLICATION

(11) **EP 1 589 073 A1**
(43) Date of publication of application: **26.10.2005**
(21) Application number: 03768356.2
(22) Date of filing: 26.12.2003
(51) Int. Cl.: C08L 101/00, C08K 3/22, H01B 3/00, H01B 3/12

(54) **COMPOSITE DEELECTRIC MATERIAL AND SUBSTRATE**

(30) Priority: 24.01.2003 JP 2003016741
(71) Applicant: TDK Corporation, Chuo-ku, Tokyo 103-8272 (JP)
(72) Inventor: ITAKURA, Keisuke, c/o TDK CORPORATION, Tokyo 103-8272 (JP); KANADA, Isao, c/o TDK CORPORATION, Tokyo 103-8272 (JP); CHIBA, Ikuka, c/o TDK CORPORATION, Tokyo 103-8272 (JP); INOUE, Masayoshi, c/o TDK CORPORATION, Tokyo 103-8272 (JP); OZAWA, Mio, c/o TDK CORPORATION, Tokyo 103-8272 (JP); CHE, Shenglei, c/o TDK CORPORATION, Tokyo 103-8272 (JP)
(74) Representative: HOFFMANN EITLE
(86) International application number: PCT/JP2003/017000
(87) International publication number: WO 2004/065489

(57) **Abstract**

An oxide of a transition metal element having at least two valences less than 4 is contained in a spherical dielectric ceramic powder. According to a composite dielectric material using the dielectric ceramic powder, the electric resistivity can be made to take such a high value as 1.0 × 10¹² Ω·cm or more while satisfactory dielectric properties are being maintained.

## Description

### Technical Field

The present invention relates to a composite dielectric material suitable for use in a high frequency band and a substrate.

### Background Art

Recently, with rapid increase of communication information, reduction in size and weight, and speedup of communication appliances are eagerly demanded. Particularly, the frequency bands of the radio waves, for use in the fields of satellite communication and mobile communication based on portable terminals such as digital cellular phones and based on car phones, falls in a high frequency band ranging from the megahertz band to the gigahertz band (hereinafter, referred to as "GHz band").

In the rapid development of the communication appliances being used, downsizing and high density mounting have been attempted for the cases, substrates, and electronic elements. For the purpose of further promoting the reduction in size and weight of the communication appliances for the high frequency bands, however, the materials for the substrates and the like used in communication appliances are required to be excellent in high frequency transmission properties (small in dielectric loss) in the GHz band.

The dielectric loss is proportional to the product of the frequency, the dielectric constant ε of the substrate, and the dielectric dissipation factor (hereinafter, represented by tanδ). Accordingly, for the purpose of reducing the dielectric loss, it is necessary to reduce the tanδ of the substrate. In addition, the wavelength of an electromagnetic wave is contracted in a substrate by a factor of 1/1/ √ε, and hence the larger is the dielectric constant ε, the smaller the substrate size can be made.

From the above, the circuit boards for the downsized communication appliances, electronic appliances, and information appliances used in a high frequency band are required to have such material properties that the dielectric constant ε is high and tanδ is small.

As the materials used for such circuit boards, dielectric ceramics materials (hereinafter, the dielectric ceramics materials will be referred to as "dielectric materials") are used as inorganic materials, while fluororesins and the like are used as organic materials. The substrates made of dielectric materials are excellent in the properties of dielectric constant ε and tanδ, but have drawbacks in dimension accuracy and machinability, and have a problem that the dielectric substrates are so brittle that they are easily chipped and cracked. On the other hand, the substrates made of organic materials such as resins and the like have the advantages of excellent moldability and machinability, and small tanδ, but have a problem that the dielectric constants ε are small. Accordingly, recently, for the purpose of obtaining substrates simultaneously having both advantages thereof, composite substrates have been proposed which are formed as composite substances of organic materials and inorganic materials by mixing dielectric materials in resin materials (for example, see Japanese Patent No. 2617639, etc.).

Accompanying the advent of such composite substrates, those dielectric materials which are excellent in dispersion properties and packing properties for resin materials are demanded. The dispersion property means the degree of dispersion of a dielectric powder in a resin material, and it is preferable that the dielectric powder is more uniformly dispersed in the resin material. The packing property means the quantity of the dielectric powder filling in the resin material. The larger is the quantity filled in the resin material, the larger the dielectric constant can be made.

A factor for a dielectric powder to acquire the dispersion properties and packing properties for resin materials is the particle size of the powder. For example, a powder produced from the liquid phase by means of such a method as a precipitation method is too fine to acquire the dispersion properties and packing properties for resin materials. On the other hand, a so-called milled powder can be obtained by mixing starting materials, drying the mixture obtained and subsequently calcining the dried mixture, then milling the calcined mixture with a milling machine such as a ball mill, or the like, and further drying with a drying machine and then finely milling with a milling machine such as a jet mill or the like. However, a powder obtained by milling is so irregular in particle shape that the dispersion properties and packing properties for resin materials cannot be acquired. In other words, another factor for a dielectric powder to acquire the dispersion properties and packing properties for resin materials is the particle shape. As a prior art paying attention to this particle shape, Japanese Patent Laid-Open No. 2002-158135 can be cited. Japanese Patent Laid-Open No. 2002-158135 discloses composite dielectric materials in which dielectrics having shapes (projected shapes) such as a circular shape, an oblate shape or an elliptic shape are dispersed in resins, and electronic parts using the composite dielectric materials. More specifically, Japanese Patent Laid-Open No. 2002-158135 describes that dielectrics having a projected shape of a circle and having a mean particle size of 1 to 50 µm and a sphericity of 0.9 to 1.0 are used.

Incidentally, in the present specification, a powder signifies an ensemble of particles; when the substance concerned is judged to be appropriately referred to as a powder as being an ensemble of particles, the substance will be referred to as "powder", and when the substance concerned is judged to be appropriately referred to as particles as being units constituting a powder, the substance will be referred to as "particles." Since the powder and the particle share the common fundamental unit, needles to say there are sometimes no substantial differences between the powder and the particle. Accordingly, there are some cases where either the expression of "powder" or the expression of "particles" can be used.

In the above-mentioned Japanese Patent No. 2617639, made a proposal wherein titanium oxide particles having a high dielectric constant is selected as dielectric material, the surfaces of the titanium oxide particles are provided with an inorganic coating composed of inorganic hydroxides and/or inorganic oxides, and the dispersion properties for resin are acquired by dispersing the coated particles in a resin material.

A substrate made of the dielectric material described in Japanese Patent No. 2617639, however, has a problem that the tanδ in the high frequency (particularly, 100 MHz or higher) band is large. In view of the tendency that in future the frequency band in use be changing over to the higher frequency bands, there is a demand for a composite dielectric material which can acquire a high dielectric constant ε and a low tanδ, that is, a high Q value (here, Q is the reciprocal of tanδ, Q = 1/tanδ).

On the other hand, in the case where the composite dielectric material disclosed in the above described Japanese Patent Laid-Open No. 2002-158135 is used, there is an advantage that the packing properties are satisfactory even when the substrate pattern has a shape making it difficult to fill the composite dielectric material in the substrate pattern. However, the composite dielectric material described in Japanese Patent Laid-Open No. 2002-158135 has a problem that when the content of the dielectric material is 30 vol% or more, where the total content of the resinmaterial and the dielectric material is represented as 100 vol%, the electric resistivity is sharply decreased. As described above, when a substrate is produced by use of a composite dielectric material, a high dielectric constant s and a low tanδ, namely, a high Q value is demanded. For the purpose of obtaining a high dielectric constant ε in a composite dielectric material, the content of the dielectric material is needed to be 30 vol% or more; however, in the composite dielectric material described in Japanese Patent Laid-Open No. 2002-158135, when the content of the dielectric material is increased in order to increase the dielectric constant ε, the electric resistivity thereof is decreased.

Accordingly, the present invention takes as its object the provision of a composite dielectric material simultaneously having a high dielectric constant ε, a low tanδ and a high electric resistivity. The present invention also takes as its object the provision of a composite dielectric material simultaneously having the above described properties and also being excellent in moldability and machinability, and hence being easily applicable to downsized appliances.

### Disclosure of the Invention

For the purpose of solving the above described problems, the present inventor made various investigations, and found that inclusion of oxides of a transition metal element having a plurality of valences in a spherical dielectric ceramic powder is extremely effective in improving the electric resistivity. More specifically, the present invention provides a composite dielectric material comprising a resin material and an approximately spherical dielectric ceramic powder to be mixed with the resin material, the composite dielectric material being characterized in that the dielectric ceramic powder is a BaO-R₂O₃-TiO₂ (R: a rare earth element, R₂O₃: an oxide of the rare earth element) based powder and comprises oxides of a transition metal element having at least two states of ionic valences less than 4.

As the dielectric ceramic powder, for example, there can be used a powder in which the sphericity of the particles is 0.8 to 1, and preferably 0.85 to 1.

It is effective in improving the dielectric constant in high frequencies to use a BaO-R₂O₃-TiO₂ based powder as a dielectric ceramic powder. When the dielectric ceramic powder is a BaO-R₂O₃-TiO₂ based powder, the valence of Ti is 4. The oxide of Ti tends to generate oxygen vacancies, and tends to be an n-type semiconductor. Thus, by introducing an additive capable of varying the valence thereof, tending to fill in the vacancies, the electric resistivity can be improved. It is a feature of the present invention that by focusing attention to this point, the electric resistivity of a composite dielectric material is improved by adding oxides of a transition metal element having at least two states of ionic valences less than 4 to be contained in an approximately spherical dielectric ceramic powder. Here, attention is focused only on such elements that are capable of taking two or more valences because such elements tend to vary the valences thereof when oxidized or reduced and hence tend to fill in the oxygen vacancies.

Examples of the transition metal elements having at least two states of ionic valences less than 4 include Mn, Cr, Fe, Co, Ni and Cu. Of these elements, Mn and Cr are preferable. Mn can take five valences of 2 to 4, 6 and 7, and moreover, Mn is a stable element when its valence is 2 or 3, so that Mn effectively functions as an acceptor. From a similar reason, Cr capable of taking four valences of 2 to 4 and 6 is also preferable as an element to be contained in an approximately spherical dielectric ceramic powder.

A preferable composition of the dielectric ceramic powder is such that BaO: 6. 67 to 21.67 mol%, R₂O₃: 6.67 to 26.67 mol%, and TiO₂: 61.66 to 76.66 mol%.

If the specific surface area of the dielectric ceramic powder is made to be as small as 1.2 m²/g or less (exclusive of 0) when producing the composite dielectric material, the electric resistivity is decreased. The present inventor investigated to overcome this adverse effect, and consequently found that by making the dielectric ceramic powder contain at least one oxide selected from a Mn oxide, a Cr oxide, a Fe oxide, a Co oxide, a Ni oxide and a Cu oxide, the decrease of the electric resistivity can be suppressed even when the specific surface area of the dielectric ceramic powder is small. In other words, the present invention provides a composite dielectric material comprising a resin material and a dielectric ceramic powder to be mixed with the resin material, the dielectric ceramic powder being characterized in that the dielectric ceramic powder comprises at least one selected from a Mn oxide, a Cr oxide, a Fe oxide, a Co oxide, a Ni oxide and a Cu oxide (hereinafter a Mn oxide, a Cr oxide, a Fe oxide, a Co oxide, a Ni oxide and a Cu oxide are collectively referred to as "the Mn oxide and the like," as the case may be) and the specific surface area of the dielectric ceramic powder is 1.2 m²/g or less (exclusive of 0).

Of the above described oxides, the Mn oxide is particularly preferable. When the Mn oxide is contained in the composite dielectric material, it is preferable that the content of the Mn oxide is 0.12 wt% or less (exclusive of 0) in terms of MnO. Inclusion of the Mn oxide in the above described range makes it possible for the electric resistivity to have such a high value as 1.0 × 10¹² Ω·cm or more, and furthermore, 1.0 × 10¹³ Ω·cm or more while satisfactory dielectric properties are being maintained.

The more preferable content of the Mn oxide is 0.01 to 0.1 wt%.

Additionally, in the composite dielectric material of the present invention, the packing properties of the dielectric ceramic powder for the resin are improved by setting at 0.8 to 1.0 the sphericity of the particles of the dielectric ceramic powder.

In the composite dielectric material of the present invention, it is preferable that the mean particle size of the dielectric ceramic powder is 0.5 to 10 µm.

According to the composite dielectric material of the present invention, there can be obtained such properties that the dielectric constant ε is 10 or more (measurement frequency: 2 GHz) and the Q value is 300 or more (measurement frequency: 2 GHz).

Moreover, in a composite dielectric material of the present invention, when the total content of a resin material and a dielectric ceramic powder is represented as 100 vol%, the content of the dielectric ceramic powder is 40 vol% or more and 70 vol% or less. Inclusion of the Mn oxide and the like in the dielectric ceramic powder makes it possible to suppress the decrease of the electric resistivity even when the content of the dielectric ceramic powder is 40 vol% or more.

Yet additionally, as the resin material in the composite dielectric material of the present invention, polyvinyl benzyl ether compounds are preferable. The polyvinyl benzyl ether compounds have such excellent electric properties that the dielectric constants ε thereof are lower and the Q values thereof are higher (ε = 2.5, Q = 260) as compared to other resin materials. Accordingly, when the polyvinyl benzyl ether compounds are used as the resin material in the present invention, there can be obtained a composite dielectric material satisfactory in dielectric properties.

Additionally, the present invention provides a substrate made of a mixture composed of a resin material and a dielectric ceramic powder, the substrate being characterized in that the dielectric ceramic powder is approximately spherical in particle shape, the content of the dielectric ceramic powder is 40 vol% or more and 70 vol% or less when the total content of the resin material and the dielectric ceramic powder is represented as 100 vol%, and the electric resistivity of the composite dielectric material is 1.0 × 10¹² Ω·cm or more. A substrate having such properties can be obtained, for example, by mixing a dielectric ceramic powder comprising the Mn oxide and the like with a resin.

Moreover, the present invention can provide a substrate comprising a base having projections on the surface thereof and a composite dielectric material coating the base having the projections formed thereon. In this substrate, the composite dielectric material can be made to comprise a resin material and a dielectric ceramic powder to be mixed with the resin material comprising a Mn oxide and being approximately spherical. As an approximately spherical dielectric ceramic powder, for example, a dielectric ceramic powder having a sphericity of 0.8 to 1 may be used.

The above described substrate of the present invention may be used for electronic parts, and particularly, suitable as an electronic part substrate to be used in the GHz band.

The substrate of the present invention exhibits such properties that the dielectric constant ε thereof is 10 or more (measurement frequency: 2 GHz) and the Q value thereof is 300 or more (measurement frequency: 2 GHz).

### Brief Description of the Drawings

Figure 1 is a flowchart showing steps for producing a spherical powder;
Figure 2 is a graph showing a variation of an electric resistivity as a function of the content variation of a dielectric ceramics;
Figure 3 is a figure showing a chemical formula of a polyvinyl benzyl ether compound;
Figure 4 is a table showing specific examples of the compound represented by formula (1) in Figure 3;
Figure 5 is a table showing the types of the additives added in Experimental Example 1 (annealing temperature: 1100°C) and the dielectric properties and the like of the composite dielectric materials obtained in Experimental Example 1;
Figure 6 is a table showing the types of the additives added in Experimental Example 1 (annealing temperature: 1150°C) and the dielectric properties and the like of the composite dielectric materials obtained in Experimental Example 1;
Figure 7 is a graph showing the electric resistivities of the composite dielectric materials produced in Experimental Example 2;
Figure 8A is a graph showing the dielectric constants ε (2 GHz) of the composite dielectric materials produced in Experimental Example 2;
Figure 8B is a graph showing the Q values of the composite dielectric materials produced in Experimental Example 2;
Figure 9A is a graph showing particle size distributions of calcined and coarsely milled powders;
Figure 9B is a graph showing particle size distributions of finely milled powders;
Figure 9C is a graph showing particle size distributions of sprayed granules;
Figure 10A is a graph showing particle size distributions of fused powders;
Figure 10B is a graph sowing particle size distributions of disintegrated powders;
Figure 11 is a table showing the variations of the dielectric properties and the electric resistivity as a function of the addition amount of MnCO₃ in Experimental Example 2 (annealing temperature: 1100°C);
Figure 12 is a table showing the variations of the dielectric properties and the electric resistivity as a function of the addition amount of MnCO₃ in Experimental Example 2 (annealing temperature: 1150°C);
Figure 13 is a table showing the compositions and the specific surface areas of dielectric ceramic powders used in Experimental Example 3, and the electric resistivities and the like of the composite dielectric materials produced in Experimental Example 3;
Figure 14 is a graph showing the relation between the specific surface area and the electric resistivity;
Figure 15A is a figure schematically showing a section of a substrate using a crushed powder;
Figure 15B is a figure schematically showing a section of a substrate using a spherical powder; and
Figure 16 is a table showing the dielectric properties and the insulation resistance of a substrate produced in Experimental Example 4.

### Best Mode for Carrying Out the Invention

Hereinafter, embodiments of the present invention will be described.

A composite dielectric material of the present invention has a feature that an oxide of a transition metal element having at least two states of ionic valences less than 4 is contained in an approximately spherical dielectric ceramic powder to be mixed with a resin material.

As a dielectric ceramic powder, those oxides based on barium titanate, lead titanate, strontium titianate, titanium dioxide, and the like, as described above, can be used. Among these, the dielectric ceramic powders based on barium titanate are preferable, and particularly, a paradielectric ceramic powder based on BaO-R₂O₃-TiO₂ (R: a rare earth element, R₂O₃: an oxide of rare earth element) and exhibiting a tungsten bronze structure shows satisfactory dielectric properties in the high frequency band and hence is preferable. Here, the rare earth element R refers to at least one element selected from the group consisting of Y, La, Ce, Pr, Nd, Pm, Sm, Eu, Gd, Tb, Dy, Ho, Er, Tm, Yb, and Lu. Among these, Nd is an abundant resource and relatively inexpensive, and hence it is preferable to select Nd as main component for the rare earth element R.

When a dielectric ceramic powder based on BaO- R₂O₃-TiO₂ is used as a dielectric ceramic powder, it is preferable that the blending is made so as for the final composition to be such that BaO: 6.67 to 21.67 mol%, R₂O₃: 6.67 to 26.67 mol%, and TiO₂: 61.66 to 76.66 mol%. In addition, the oxides of Bi, Zr, Ta, Ge, Li, B, Mg, and the like may be appropriately added to the composition based on a BaO-R₂O₃-TiO₂ material. By adding Bi, the temperature stability is improved, and simultaneously the dielectric constant ε is also improved. In addition, Zr, Ta, Ge, Li, B, and Mg are effective for improvement of the temperature stability.

Next, description will be made on oxides, to be contained in the dielectric ceramic powder, of transition metal elements which have specific states of valences. Examples of such oxides of transition metal elements include a Mn oxide, a Cr oxide, a Fe oxide, a Co oxide, a Ni oxide and a Cu oxide. As shown below, Mn, Cr, Fe, Co, Ni and Cu are all such elements that can take two or more valences. More specifically, any one of these elements has at least two states of ionic valences less than 4.
Mn²⁺, Mn³⁺, Mn⁴⁺, Mn⁶⁺, Mn⁷⁺
Cr²⁺, Cr³⁺, Cr⁴⁺, Cr⁶⁺
Fe²⁺, Fe³⁺
Ni²⁺, Ni³⁺
Cu²⁺, Cu³⁺

The elements such as Mn are prepared as oxide powders or carbonate powders. As will be described later, the elements such as Mn are added before the dielectric ceramic powder to be a matrix is spheroidized; the matrix is composed of oxides, so that the elements such as Mn are oxidized during melting. Consequently, the elements such as Mn are eventually contained as oxides in the dielectric ceramic powder.

The content of the Mn oxide in the composite dielectric material is set at 0.12 wt% (exclusive of 0) in terms of MnO. Similarly, the content of the Cr oxide, the content of the Fe oxide, the content of the Co oxide, the content of the Ni oxide, and the content of the Cu oxide may be set respectively as follows:
Cr oxide content: 0.12 wt% or less (exclusive of 0) in terms of Cr₂O₃;
Fe oxide content: 0.12 wt% or less (exclusive of 0) in terms of Fe₂O₃;
Co oxide content: 0.12 wt% or less (exclusive of 0) in terms of Co₃O₄;
Ni oxide content: 0.12 wt% or less (exclusive of 0) in terms of NiO;
Cu oxide content: 0.12 wt% or less (exclusive of 0) in terms of CuO;

Inclusion of the Mn oxide and the like within the above described ranges makes it possible to improve the electric resistivity while the high dielectric properties are being maintained. In particular, when the contents of the Mn oxide and the like in the composite dielectric material are set at 0.01 to 0.1 wt% or less, the electric resistivity of the composite dielectric material can be made to be 1.0 × 10¹² Ωcm or more. It is to be noted that the contents of the Mn oxide and the like are the converted values derived from the contents of Mn, Cr and the like after firing.

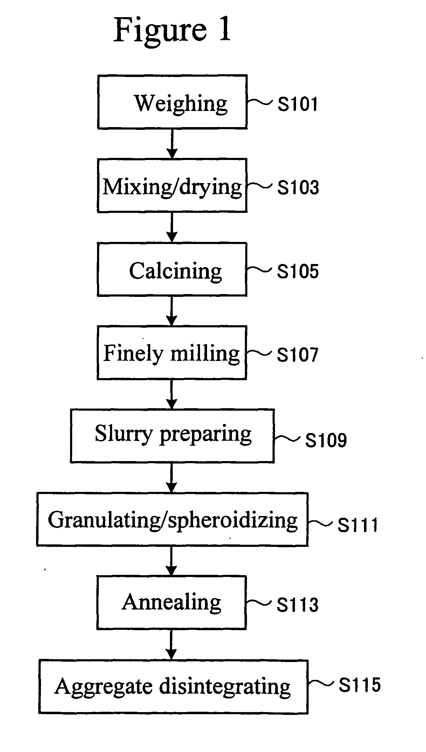

The dielectric ceramic powder of the present invention comprising the Mn oxide and the like has a shape close to a true sphere in such a way that the sphericity of the particles thereof is 0.8 to 1. With reference to Figure 1, description will be made below on a method suitable for obtaining such a spherical dielectric ceramic powder. Needless to say, in the present invention, a spherical dielectric ceramic powder can be obtained by use of methods other than the method to be described below.

Figure 1 is a flowchart showing steps for producing a spherical dielectric ceramic powder involved in the present invention.

As shown in Figure 1, in the present embodiment, a spherical dielectric ceramic powder comprising oxides of transition metal elements is produced by passing through a weighing step (step S101), a mixing/drying step (step S103), a prefirng step (step S105), a finely milling step (step S107), a slurry preparing step (step S109), a granulating/spheroidizing step (step S111), an annealing step (step S113), and an aggregate disintegrating step (step S115). The respective steps will be described below in detail.

At the beginning, starting materials are weighed in the weighing step (step S101). For example, BaO, an R compound (for example 2Nd (OH)₃), TiO₂ and MnCO₃ are respectively weighed when it is intended to finally obtain a dielectric ceramic powder which has a composition based on BaO-R₂O₃-TiO₂ and contains a Mn oxide.

In the successive mixing/drying step (step S103), a dispersant is added to each of the starting material powders weighed in the weighing step (step S101). The mixtures thus obtained are mixed by use of a ball mill or the like. The addition amount of the dispersant may be set at about 0.1 to 0.3 wt% in terms of the solid content in relation to the total amount of the starting material powders. The mixture added with the dispersant is placed in the vat or the like, and dried for about 10 to 40 hours. Then, the calcining step (step S105) is undertaken.

In the calcining step (step S105), the mixed material added with the dispersant is fired at 1100 to 1400°C for about 1 to 5 hours. In the finely milling step (step S107), the calcined mixed material is finely milled until the mean particle size thereof reaches 0.8 to 1.2 µm. In finelymilling, a ball mill may also be used.

In the slurry preparing step (step S109), a dispersion medium is added in a content of about 0.1 to 0.3 wt% in terms of solid content to the finely milled mixed material, and then mixed with a mixing machine such as a ball mill or an attriter to prepare a slurry. Water may be used as dispersion medium, and addition of a dispersant is recommended in order to improve the dispersion properties of the starting material powders. A bonding agent for mechanically binding the starting material powders, such as PVA (polyvinyl alcohol), can also be added.

In the successive granulating/spheroidizing step (step S111), a granular powder is prepared by use of a spray granulation method using a spray nozzle, and the obtained granular powder is melted in a burner furnace to prepare a spherical powder. More specifically, at the beginning, the slurry (a slurry containing the starting material powders) prepared in the slurry preparing step (step S109) is sprayed by use of a spray nozzle, a revolving disc, or the like to form droplets.

Here, the spray nozzle is a device for use in spraying the above mentioned slurry and a compressed gas, and there can be used a two-fluid nozzle or a four-fluid nozzle.

The slurry discharged from the spray nozzle together with the compressed gas is converted to fine particles to formmist. The droplet size in the mist can be controlled by the ratio between the slurry and the compressed gas. By controlling the droplet size, the particle size of the granules finally obtained can be controlled. By supplying the heat for drying the moisture during the process where the slurry in a mist state falls down freely, there can be obtained a powder from which the liquid component is dried and removed. The heat can be supplied by making the gas discharged from the spray nozzle to be a heated gas, or by feeding a heated gas into the mist atmosphere. For the purpose of drying, a gas heated to 100°C or more can be used. The processes of spraying and drying with the spray nozzle are performed in a prescribed chamber. A powder obtained by the spray granulation method using a spray nozzle is usually a granular powder. The particle size of the granular powder, as described above, can be controlled by the ratio between the slurry and the compressed gas. Fine droplets can also be formed by making the droplets of the slurry to collide with each other.

The granular powder obtained as described above is fed into a combustion flame. The fed granular powder stays in the combustion flame during a prescribed period of time. During that stay, the granular powder undergoes a heat treatment. Specifically, the granular powder is melted to form spherical particles. When the granular powder is composed of two or more than two kinds of particles, the particles react with each other so as to finally form the desired dielectric material such as one containing Mn oxide and the like. The granular powder being fed into the combustion flame can be fed in a dry state, and additionally it can also be fed in a wet state as a slurry containing the granular powder.

As for the combustion gas for obtaining the combustion flame, there is no particular restrictions, and such gases well known in the art as LPG, hydrogen, acetylene, or the like can be used. In the present invention, it is necessary to control the oxidation degree of the combustion flame, since oxides are processed in the present invention, and it is desired to supply an appropriate amount of oxygen to the combustion gas. When LPG is used as the combustion gas, the oxygen amount of five times the supply amount of LPG is equivalent to the LPG amount, when acetylene is used as the combustion gas, the oxygen amount of 2.5 times the supply amount of acetylene is equivalent to the acetylene amount, and when hydrogen is used as the combustion gas, the oxygen amount of 0.5 times the supply amount of hydrogen is equivalent to the hydrogen amount. By appropriately setting the supply amount of oxygen, with reference to these oxygen amounts, the oxidation degree of the combustion flame can be controlled. The flow rates of these combustion gases can be appropriately determined according to the size of the burner.

The temperature of a combustion flame is varied by the kind and amount of the combustion gas, the ratio thereof to the oxygen amount, the feeding rate of the granular powder, and the like. When LPG is used as the combustion gas, the temperatures up to about 2100°C can be obtained, and when acetylene is used as the combustion gas, the temperatures up to about 2600°C can be obtained.

As for the technique of feeding a granular powder into a combustion flame, there is no restrictions as far as the granular powder is allowed to enter the combustion flame. In addition to this, the granular powder is preferably fed along the combustion flame axis from the burner, in order to prolong the transit time of the granular powder passing through the flame. Accordingly, it is preferable that the granular powder is adjusted not to leak out of the combustion flame before the granular powder reaches the combustion flame bottom.

The feeding of the granular powder is made by using such a carrier gas as oxygen or the like. When a granular powder having a satisfactory fluidity is used, the conveyance performance by the carrier gas is enhanced. Incidentally, in a case where a milled powder is delivered by using a carrier gas, the irregularity in shape and the wide width of the size distribution of a milled powder cause a poor fluidity and an unsatisfactory conveyance performance. Needless to say, it is necessary to increase the amount of a carrier gas for the purpose of increasing the feeding amount of a granular powder, and in the case where oxygen is used as the carrier gas, it is necessary to reduce the amount of oxygen which is the supporting gas, and to adjust the mixing ratio between the carrier gas and oxygen.

After passing through the granulating/spheroidizing step (step S111), the annealing step (step S113) is undertaken. In the annealing step (step S113), the spherical granular powder is maintained at the heat treatment temperatures of 1000 to 1300°C for about 2 to 5 hours. The annealing step (step S113) recrystallizes the spherical granular powder made amorphous in the granulating/spheroidizing step (step S111). The heat treatment atmosphere may be, for example, the air atmosphere.

Sometimes, the melting in the above described granulating/spheroidizing step (step S111) makes the powder particles mutually react to be partially bonded to each other. It is the aggregate disintegrating step (step S115) that is carried out in order to break this bonding. The aggregate disintegrating step (step S115) disintegrates the partially bonded particles by use of a ball mill or the like.

The mean particle size of the spherical powder obtained by passing through the above described steps S101 to S115 is about 0.1 to 50 µm; in particular, particles of about 0.5 to 10 µm in mean particle size can be obtained (For the measurement of themeanparticle size, Microtrac manufactured by Nihonseiki Kaisha, Ltd. was used. This is also the case for the below described examples).

When a composite dielectricmaterial is obtained by mixing a dielectric ceramic powder with a resin, the mean particle size of the dielectric ceramic powder is adjusted to be 0.5 to 10 µm. When the mean particle size of the dielectric ceramic powder is smaller than 0.5 µm, it is difficult to obtain high dielectric properties, in particular, to obtain a dielectric constant ε of 8 or more at 2 GHz, furthermore a dielectric constant ε of 10 or more at 2 GHz. In addition, in a case where the mean particle size of the dielectric ceramic powder is so smaller than 0.5 µm, there occurs such an inconvenience that the kneading with the resin is not easy, and in addition, the handling becomes cumbersome as such that the particles of the dielectric ceramic powder aggregate and accordingly a non-uniform mixture is formed, and the like.

On the other hand, when the mean particle size of the dielectric ceramic powder exceeds 10 µm, the dielectric properties are satisfactory, but there occurs a problem that the pattern formation for a substrate becomes so tough that it is difficult to obtain a thin and flat substrate. Consequently, the mean particle size of the dielectric ceramic powder is made to be 0.5 to 10 µm. The preferable mean particle size of the dielectric ceramic powder is 1 to 6 µm, and the more preferable mean particle size is 1 to 3 µm. By making the mean particle size of the dielectric powder 0.5 to 10 µm, it becomes possible to obtain a dielectric constant ε of 10 or more and a Q value of 300 or more in a high frequency region of 2 GHz as well.

By using the above described method, a dielectric ceramic powder with the sphericity of 0.8 to 1 can be obtained, and further a dielectric ceramic powder with the sphericity of 0.85 to 1, furthermore 0.9 to 1 can be obtained. When a dielectric ceramic powder with the sphericity of 0.8 or more is used, it becomes easy to disperse the dielectric ceramic powder uniformly in a resin.

Here, "spherical" includes polyhedrons very close to a true sphere, in addition to a true sphere with smooth surface. Specifically, there is also included a polyhedron particle, having an isotropic symmetry and being enclosed by stable crystal surfaces, as represented by the Wulff model, and in addition having a sphericity close to 1. Even those particles which have fine concavities and convexities on the surface or elliptic sections fall under the category of being "spherical" in the terminology of the present invention, when the sphericity falls within the range 0.8 to 1. Here, the "sphericity" is the practical sphericity of Wadell, that is, the sphericity of a particle is the ratio between the diameter of a circle which has the same area as the projected area of the particle and the diameter of the minimum circle circumscribing the projected image of the particle.

In the present invention, when two or more than two particles are bonded by fusion, the individual particles are regarded as one particle for the calculation of the sphericity. When there is a protrusion, a similar treatment is made. In the above, an example has been described in which BaO, an R compound (for example 2Nd (OH)₃), TiO₂ and MnCO₃ as the starting material powders are mixed together in the mixing/drying step (step S103). However, the timing of the addition of MnCO₃ to eventually be a Mn oxide is not limited to that in the above description. In other words, because MnCO₃ has only to be added in advance of the granulating/spheroidizing step (step S111), MnCO₃ may be added, for example, in the finely milling step (step S107).

In the composite dielectric material of the present invention, when the total content of a dielectric ceramic powder and a resin is represented as 100 vol%, the content of the dielectric ceramic powder is 40 vol% or more and 70 vol % or less. When the content of the dielectric ceramic powder is less than 40 vol% (the content of the resin exceeds 60 vol%), the packing properties of the dielectric ceramic powder are degraded, and the dielectric constant ε is decreased. In other words, no appreciable effect of containing the dielectric ceramic powder is found. On the other hand, when the content of the dielectric ceramic powder exceeds 70 vol% (the content of the resin is less than 30 vol%), the fluidity is extremely degraded when press molded, so that no dense molded product can be obtained. As a result, water invasion or the like becomes easy, leading to degradation of the electric properties. Additionally, as compared to the case where no dielectric ceramic powder is added, sometimes the Q value is largely decreased. Consequently, the content of the dielectric ceramic powder is set to be 40 vol% or more and 70 vol% or less. The content of the dielectric ceramic powder is preferably 40 to 65 vol%, and more preferably 45 to 60 vol%. The optimal content of the dielectric ceramic powder varies according to the substrate pattern shape in such a way that the content of the dielectric ceramic powder is preferably about 45 to 55 vol% when the substrate pattern shape is relatively fine.

Since as described above the dielectricceramic powder of the present invention is spherical, the dispersion properties for resin are satisfactory even when the content of the dielectric ceramic powder is set to be 40 vol% or more, and furthermore 50 vol% or more, and the dielectric ceramic powder can be filled in without degrading the fluidity of the resin material. Accordingly, when a dielectric powder of the present invention is mixed with a resin material, and a substrate is produced by use of the mixture, the filled-in amount of the dielectric powder is improved as compared with the case where milled powder is used, and as a result a substrate having a high dielectric constant ε can be obtained.

On the contrary, when there is used a non-spherical dielectric ceramic powder such as a milled powder prepared by a conventional method, the fluidity of the resin material is deteriorated when the content of the dielectric ceramic powder in a substrate becomes about 40 vol%, and hence it :is very difficult to make the content of the dielectric ceramic material in a substrate 45 vol% or more. Granted that the content of the dielectric ceramic powder in a substrate is permitted to be 45 vol% or more, it is difficult for the dielectric ceramic powder to fill in the pattern edges and the like in producing a substrate, and consequently there is obtained a substrate having voids in some portions thereof and accordingly having a low strength.

Now, description will be made on an advantage provided by making the dielectric ceramic powder contain the oxides, such as the Mn oxide and the like, of a transition metal element having at least two states of ionic valences less than 4.

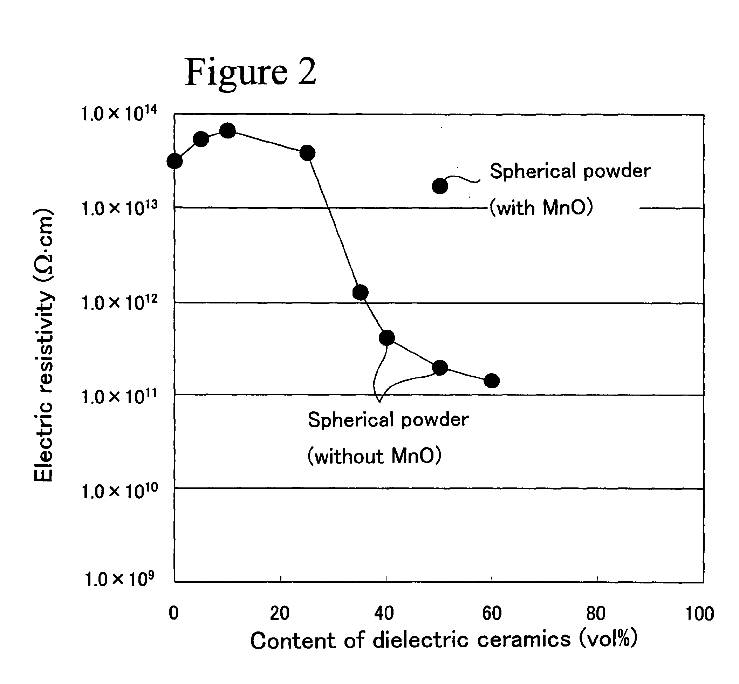

Figure 2 is a graph showing a variation of an electric resistivity as a function of the content variation of a dielectric ceramics. In Figure 2, the final composition of a spherical powder (with MnO) is such that 16.596BaO-38.863Nd₂O₃-41.702TiO₂-2.751Bi₂O₃-0.088MnO (wt%). On the other hand, the final composition of a spherical powder (without MnO) is such that 18.932BaO-41.188Nd₂O₃-39.88TiO₂ (wt%).

As shown in Figure 2, the spherical powder containing no Mn oxide in the final composition thereof exhibits a high dielectric constant ε of 1.0 × 10¹² Ω·cm or more when the content of the dielectric ceramics is as low as 30 vol% or less. However, when the content of the dielectric ceramic powder is 40 vol% or more, the electric resistivity is decreased down to the vicinity of 1.0 × 10¹¹ Ω·cm. On the contrary, the spherical powder containing a Mn oxide in the final composition thereof can maintain a high electric resistivity even when the content of the dielectric ceramic powder is 50 vol%. From the above results, it has been found that a spherical powder containing a Mn oxide in the final composition thereof can maintain a high electric resistivity of 1.0 × 10¹² Ω·cm or more, and furthermore, 1.0 × 10¹³ Ω·cm or more even when the content of the dielectric ceramic powder is set to be 40 vol% or more (in other words, the content of the dielectric ceramic powder is set to be the content required for obtaining a high dielectric constant ε). In Figure 2, description has been made on an example in which a Mn oxide is used as the oxide of a transition metal element having at least two states of ionic valences less than 4; however, similar effects can be obtained even when there are used other transition metal elements having at least states of ionic valences less than 4, for example, a Cr oxide, a Fe oxide, a Co oxide, a Ni oxide, a Cu oxide and the like.

In the above, description has been mad on the case where a dielectric ceramic powder and a spherical powder are used. The improvement of the electric resistivity owing to inclusion of the Mn oxide and the like is remarkable when the specific surface area of the dielectric ceramic powder is 1.2 m²/g or less. With decreasing specific surface area of the dielectric ceramic powder, the electric resistivity tends to be decreased. However, inclusion of a predetermined amount of the Mn oxide recommended by the present invention in a dielectric ceramic powder makes it possible to obtain an electric resistivity of 1.0 × 10¹² Ω·cm or more even when the specific surface area of the dielectric ceramic powder is 1.2 m²/g or less, and furthermore, 1.0 m²/g or less.

Now, description will be made on the resin material in the composite dielectric material of the present invention. As the resin material, organic polymer resins are preferable. The organic polymer resin is preferably a heat-resistant and low-dielectric-property polymer material which is a resin composite composed of one or more kinds of resins with the weight-average absolute molecular weight of 1000 or more, and in which the sum of the number of the carbon atoms and the number of the hydrogen atoms is 99% or more in ratio, and a part of the resin molecules or the whole resin molecules are chemically bonded to each other. By using an organic polymer resin having such a constitution as above, there can be obtained a composite dielectric material having a high dielectric constant ε and a high Q value in a high frequency region.

As described above, a heat-resistant and low-dielectric-property polymer material, made of a resin composite with the weight-average absolute molecular weight of 1000 or more, is used for the purpose of attaining sufficient strength, adherence to metal, and heat resistance. With a weight-average absolute molecular weight smaller than 1000, there occur insufficiencies in mechanical properties and heat resistance properties.

The reason why the sum of the number of the carbon atoms and the number of the hydrogen atoms is made to be 99% or more in ratio is that the chemical bonds present in the polymer material are made to be non-polar bonds, and thereby it becomes easy to obtain a high Q value. On the other hand, the Q value becomes small, when the sum of the number of the carbon atoms and the number of the hydrogen atoms is smaller than 99% in ratio, in particular, when the number of the contained atoms forming polar molecules such as oxygen atoms and nitrogen atoms is larger than 1% in ratio.

The weight-average absolute molecular weight is particularly preferably 3000 or more, and furthermore preferably 5000 or more. In this connection, there is no particular limit to the upper limit for the weight-average absolute molecular weight, but usually the upper limit is about ten millions.

As specific examples of the above described organic polymer resins, there can be listed homopolymers and copolymers (hereinafter, sometimes referred to as (co)polymers) of non-polar α-olefins such as low density polyethylene, ultra low density polyethylene, superultra low density polyethylene, high density polyethylene, low molecular weight polyethylene, ultra high molecular weight polyethylene, ethylene-propylene copolymers, polypropylene, polybutene, poly-4-methylpentene, and the like; (co) polymers of conjugated diene monomers such as butadiene, isoprene, pentadienes, hexadienes, heptadienes, octadienes, phenylbutadienes; diphenylbutadienes, and the like; and (co)polymers of carbon-ring containing vinyl monomers such as styrene, nuclear substituted styrenes such as methylstyrenes, dimethylstyrenes, ethylstyrenes, isopropylstyrenes, chlorostyrenes, α-substituted styrenes such as α-methylstyrene, α-ethylstyrene, divinylbenzenes, vinylcyclohexanes, and the like.

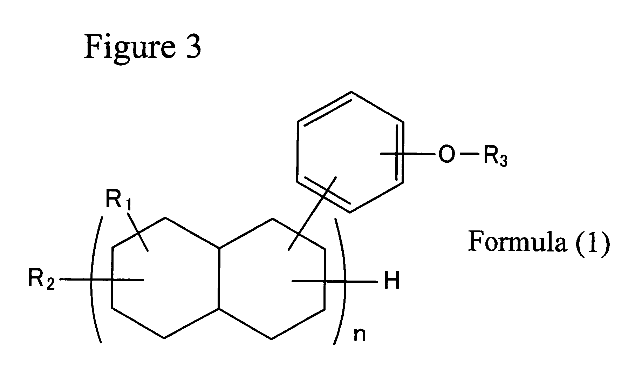

As a resin used in the present invention, the polyvinyl benzyl ether compounds are particularly preferable. As the polyvinyl benzyl ether compounds, those compounds represented by formula (1) shown in FIG. 3 are preferable.

In formula (1), R₁ represents a methyl group or an ethyl group. R₂ represents a hydrogen atom or a hydrocarbon group having 1 to 10 carbon atoms. The hydrocarbon groups represented by R₂ are an alkyl group, an aralkyl group, an aryl group, and the like, each of which groups may contain substituents. The alkyl group may be a methyl group, an ethyl group, a propyl group, a butyl group, or the like. The aralkyl group may be a benzyl group or the like, and the aryl group may be a phenyl group or the like.

R₃ represents a hydrogen atom or a vinylbenzyl group, the hydrogen atom stems from a starting compound for synthesis of the compound of formula (1), and the molar ratio of the hydrogen atom to the vinylbenzyl group is preferably 60: 40 to 0: 100, and more preferably 40: 60 to 0: 100.

In formula (1), n is a number of 2 to 4.

By making the molar ratio of the hydrogen atom of R₃ to the vinylbenzyl group of R₃ to fall within the above ranges, the curing reaction when obtaining a dielectric compound can be proceeded to a sufficient extent, and satisfactory dielectric properties can be obtained. On the contrary, when the unreacted compound in which R₃ is a hydrogen atom is increased in content, the curing reaction does not proceed to a sufficient extent, and no satisfactory dielectric properties can be obtained.

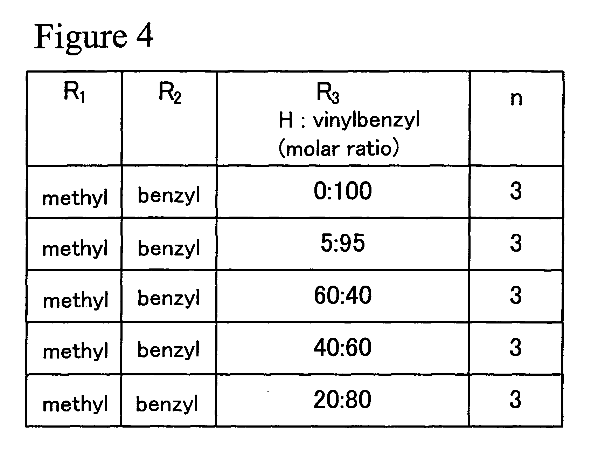

Specific examples for the compound represented by the above described formula (1) are shown in FIG. 4 under the combination of R₁ and the like, the combination is not limited to these examples.

The compound represented by formula (1) is obtained by reacting a polyphenol with R₃ = H in formula (1) and a vinylbenzyl halide. As for the details of the reaction, the descriptions in Japanese Patent Laid-Open No. 9-31006 can be referred to.

The polyvinyl benzyl ether compounds of the present invention may be used each alone or in combination of two or more kinds of compounds thereof. A polyvinyl benzyl ether compound of the present invention may be used alone in a polymerized form as a resin material, or may be used as polymerized with other monomers, or furthermore can be used in combination with other resins.

As polymerizable monomers, there can be listed, for example, styrene, vinyltoluenes, divinylbenzenes, divinylbenzyl ethers, allyl phenol, allyloxy benzenes, diallyl phthalates, acrylic acid esters, methacrylic acid esters, vinyl pyrrolidones, and the like. As for the blending ratios for these monomers, the blending ratio is about 2 to 50 mass% to a polyvinyl benzyl ether compound.

As resins usable in combination, there are thermosetting resins such as vinyl ester resins, unsaturated polyester resins, maleimide resins, polycyanate resins of polyphenols, epoxy resins, phenol resins, vinylbenzyl compounds and the like; and thermoplastic resins such as polyether imide resins, polyether sulfones, polyacetals, resins based on dicyclo pentadienes. As for the blending ratios for these resins, the blending ratio is about 5 to 90 mass% to a polyvinyl benzyl ether compound of the present invention. Among these resins, preferable resin is at least one selected from a group consisting ofvinylester resins, unsaturated polyester resins, maleimide ester resins, polycyanate resins of polyphenols, epoxy resins, and the mixtures of these resins.

The polymerization and curing of either the polyvinyl benzyl ether compounds themselves of the present invention, or the thermosetting resin composites containing these compounds and other monomers or thermosetting resins, can be performed by a method well known in the art. The curing can be performed either in the presence or in the absence of a curing agent. As a curing agent, there can be used a radical polymerization initiator well known in the art such as benzoyl peroxide, methyl ethyl ketone peroxide, dicumyl peroxide, t-butyl perbenzoate, or the like. The usage amount of an initiator is 0 to 10 mass parts to 100 mass parts of a polyvinyl benzyl ether compound.

The curing temperature is varied depending on whether a curing agent is used and according to the type of the curing agent used, and it is 20 to 250°C, and preferably 50 to 250°C for a sufficient curing.

For curing regulation, hydroquinone, benzoquinone, copper salts, and the like may be blended.

A reinforcing material can be added to a resin of the present invention. A reinforcing material is effective in improving the mechanical strength and the dimension stability, and hence usually a prescribed amount of a reinforcing material is added to the resin in producing a circuit board.

As the reinforcing materials, there can be listed fibrous reinforcing materials or plate-like or granular non-fibrous reinforcing materials. Among the fibrous reinforcing materials, here can be listed inorganic fibers such as glass fiber, alumina fiber, aluminum borate fiber, ceramics fiber, silicon carbide fiber, asbestos fiber, gypsum fiber, brass fiber, stainless fiber, steel fiber, metal fibers, magnesium borate whisker or fiber thereof, potassium titanate whisher or fiber, zinc oxide whisker, boron whisker fiber, and the like; and carbon fiber, aromatic polyamide fibers, aramide fibers, polyimide fibers, and the like. When a fibrous reinforcing material is used, there can be adopted a so-called impregnation method described in Japanese Patent Laid-Open No. 2001-187831. Namely, the point is that a fibrous reinforcing material molded in a sheet shape is immersed in a coating vessel in which the dielectric powder and the resin are mixed to prepare a slurry.

As the non-fibrous reinforcing materials, there can be listed needle-like, plate-like, or granular reinforcing materials which are silicates such as wollastonite, sericite, kaolin, mica, clay, bentonite, asbestos, talc, alumina silicate, pyrophyllite, montmorillonite, and the like; molybdenum disulfide, alumina, silicon chloride, zirconium oxide, iron oxides; carbonates such as calcium carbonate, magnesium carbonate, dolomite, and the like; sulfates such as calcium sulfate, barium sulfate, and the like; calcium polyphosphate, graphite, glass bead, glass microballoon, glass flake, boron nitride, silicon carbide, and silica. These materials may be hollow. When a non-fibrous reinforcing material is used, it only has to be added to a resin.

These reinforcing materials may be used each alone, or can be used in combination with two or more than two kinds of materials thereof, and if need be, can be applied a pretreatment with coupling agents based on silane or titanium. A particularly preferable reinforcing material is glass fiber. As for the type of glass fiber, there is no particular limitation to it, and there can be used those which are generally used in reinforcing resins. The glass fiber to be used can be selected from, for example, chopped strands of long fiber type and short fiber type, chopped strand mat, continuous long fiber mat, cloth-like glass such as fabric, knit fabric, or the like, and milled fiber.

The content of a reinforcing material in a composite dielectric material preferably falls in the range from 10 to 30 wt%, and more preferably from 15 to 25 wt%.

A composite dielectric material of the present invention is preferably produced by the following method.

At the beginning, a dielectric powder having spherical particle shape (or having a specific surface area of 1.2 m²/g or less) and containing Mn oxide and the like is obtained according to the above described method. Then, the dielectric powder having spherical particle shape (or having a specific surface area of 1.2 m²/g or less) and a resin are mixed together in prescribed amounts. The mixing can be performed, for example, by a dry mixing method, but it is preferable that the mixing is fully performed in an organic solvent such as toluene, xylene, or the like by use of a ball mill, a stirring machine, or the like.

The slurry thus obtained is dried at 90 to 120°C to obtain the chunks composed of the dielectric powder and the resin. The chunks are milled to obtain the mixed powder composed of the dielectric powder and the resin. The process from slurry to mixed powder preferably uses a production apparatus of granular powder such as a spray drier, or the like.

The mean particle size of the mixed powder is recommended to be about 50 to 1000 µm.

Then, the mixed powder undergoes press molding at 100 to 150°C into a desired shape, and the molded substance is cured at 100 to 200°C for 30 to 480 min. In the course of this curing process, a reinforcing material described above is allowed to be involved.

As for the composite dielectric material of the present invention, as described above, a dielectric powder is preferably mixed in before the polymerization or the curing of a resin such as a polyvinyl benzyl ether compound, or the like, but it may be mixed in after the polymerization or the curing as the case may be. It is not preferable, however, that the dielectric powder is mixed in after completion of curing.

A composite dielectric material of the present invention can be used in a variety of shapes such as film, a molded body in bulk form or in a prescribed shape, a film lamination, or the like. Accordingly, it can be used for a variety of substrates for use in electronic equipments and electronic parts (resonators, filters, condensers, inductors, antennas, and the like) for use in the high frequency band; for filters (for example, a C filter which is a multilayer substrate) and resonators (for example, a triplate resonator) as chip parts; for supporting bases for dielectric resonators or the like; furthermore, for housings for a variety of substrates or electronic parts (for example, an antenna rod housing) ; for casings, and for electronic parts and housings or casings thereof, or the like. As for the substrates, they are expected to be alternative to conventional glass fabric based eopoxy resin substrates, and specifically examples include on-board substrates for use in mounting parts, copper-clad laminates, metal based/metal core substrates, and the like. Furthermore, the substrates can be used for circuit integrated boards and antenna substrates (patch antenna and the like). In addition, they can be used for on-board substrates for CPU.

Incidentally, in formation of an electrode, a composite dielectric powder is placed between metal foil sheets of copper or the like, and cured while pressing; or a foil sheet of copper or the like is attached to one side surface of a molded body of the composite dielectric powder, or two metal foil sheets on both side surfaces, before completion of curing, and the curing can be performed while pressing. In addition, an electrode can be formed as follows: a temporary curing is performed after attaching metal foil sheet by pressing, and subsequently a separate curing is performed by heat treatment; and the molded substance is cured, and then undergoes the metal evaporation, metal sputtering, electrolytic-less plating, or coating with (resin) electrode or the like.

A composite dielectric material of the present invention and a board using thereof can be used suitably in the GHz band, and can have a dielectric constant ε of 10 or more and a Q value of 300 or more in the case of the 2 GHz band. Moreover, the composite dielectric material of the present invention and the substrate using thereof can have an electric resistivity of 1.0 × 10¹² Ω·cm or more while they are maintaining these high dielectric properties.

### (Examples)

Now, the present invention will be described in more detail with reference to specific examples.

### [Experimental Example 1]

An experiment carried out for checking the preferable additives for the dielectric ceramic powder will be described as Experimental Example 1.

### (Example 1)

As starting material powders, a BaCO₃ powder, a TiO₂ powder and a Nd₂O₃ powder were prepared in an total amount of 1.5 kg, and mixed in pure water to prepare a slurry having a concentration of 60%. To 2.5 kg of this slurry, 30 cc of a dispersant (brand name: A-30SL (10% solution) manufactured by Toa Gosei Co., Ltd.) was added, and the mixture obtained was mixed by use of a ball mill at a rotation speed of 85 rpm for 16 hours. Then, the mixed material was dried for 24 hours, and thereafter calcined at 1225°C in the air for 2 hours to yield a dielectric ceramics material. The dielectric ceramics material was converted into a slurry having a concentration of 60% by using water, and finely pulverized with a ball mill so as for the mean particle size thereof to be 0.4 to 1.5 µm. The slurry was dried to yield a dielectric ceramic powder. To the powder, MnCO₃ was added as an additive in a content of 0.025 to 0.2 wt%, and then water was added to yield a slurry having a concentration of 60%. To 3.1 kg of this slurry, 200 cc of a PVA (polyvinyl alcohol) solution (brand name: PVA 205C (15% solution) manufactured by Kuraray Co., Ltd.) and 40 cc of the above described dispersant were added, and the mixture obtained was mixed for 15 hours by use of a ball mill at a rotation speed of 85 rpm to prepare a slurry. The slurry was subjected to spray granulation by use of a spray drier to prepare a granular powder. Then, by applying the above described method, a spherical dielectric ceramic powder was prepared. It is to be noted that the settings of the spray drier and a burner furnace, and the conditions of annealing and disintegration were as follows. The mean particle size of the finally obtained powder was 3.8 to 4.9 µm, and the sphericity of the particles constituting the powder reached 0. 85 to 0. 92. An analysis of the composition of the spherical dielectric ceramic powder was conducted to confirm that BaO, Nd₂O₃, TiO₂ and MnO were contained.

### <Setting of the spray drier>

Inlet temperature: 180°C
Slurry feed rate: 50 g/min (slurry concentration: 60%)

### <Setting of the burner furnace>

O₂ feed rate: 25 L/min
N₂ feed rate: 20 L/min (for use in transferring granules)
LPG feed rate: 5 L/min

### <Conditions of annealing>

Example 1 and Comparative Examples 1 to 4: Firing was conducted in the air at 1000°C for 4 hours.

### <Conditions of disintegration>

Disintegration was conducted at a rotation speed of 120 rpm for 4 hours.

### (Comparative Example 1)

A spherical dielectric ceramic powder was prepared under the same conditions as in Example 1 except that Bi₂O₃ was added as additive in place of MnCO₃.

### (Comparative Example 2)

A spherical dielectric ceramic powder was prepared under the same conditions as in Example 1 except that SiO₂ was added as additive in place of MnCO₃.

### (Comparative Example 3)

A spherical dielectric ceramic powder was prepared under the same conditions as in Example 1 except that CaCO₃ was added as additive in place of MnCO₃.

### (Comparative Example 4)

A spherical dielectric ceramic powder was prepared under the same conditions as in Example 1 except that no additive was added.

Next, a resin was mixed in each of the spherical powders prepared in Example 1 and Comparative Examples 1 to 4 to yield 5 composite dielectric materials. The content of the dielectric ceramic powder in each of the composite dielectric materials was set at 50 vol%, and the polyvinyl benzyl ether compounds represented by formula (1) in Figure 3 were used as resin.

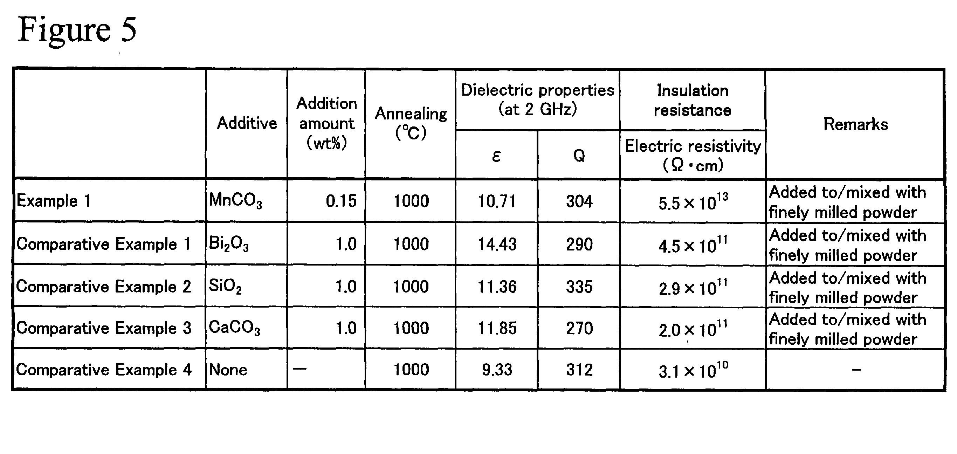

For each of the 5 composite dielectric materials, the dielectric constant ε (2 GHz) was measured by means of the cavity resonator method (a perturbation method) (a scalar synthesizer sweeper 83620A and a network analyzer 8757C manufactured by Hewlett Packard, Inc. were used). The Q values were also measured. The results obtained are shown in Figure 5. The electric resistivities were also measured by means of an ultra high resistance meter, Advantest R8340A, manufactured by Hewlett Packard, Inc., and the results obtained are also shown in Figure 5.

As can be seen from Figure 5, Example 1 and Comparative Examples 1 to 3, each containing an additive, exhibited higher electric resistivities than Comparative Example 4 containing no additive. It is worth noting that, of Example 1 and Comparative Examples 1 to 3 each containing an additive, a sample added with MnCO₃ as additive (Example 1) exhibited a highest electric resistivity of 5.5 × 10¹³ Ω·cm in spite of such a small addition amount as 0.15 wt%. Additionally, this sample (Example 1) exhibited such satisfactory dielectric properties that the dielectric constant ε at 2 GHz and the Q value were 10.71 and 304, respectively.

On the other hand, the sample (Comparative Example 1) added with Bi₂O₃ as additive, the sample (Comparative Example 2) added with SiO₂ as additive, and the sample (Comparative Example 3) added with CaCO₃ as additive exhibited higher electric resistivities than Comparative Example 4 without additive; however, the values concerned were such insufficient values as 2.0 × 10¹¹ Ω·cm to 4.5 × 10¹¹ Ω·cm. The sample (Comparative Example 1) added with Bi₂O₃ as additive and the sample (Comparative Example 3) added with CaCO₃ as additive exhibited such low Q values as 300 or less, namely, 290 and 270, respectively.

From the above results, it has been found that by adding MnCO₃ as additive, a composite dielectric material exhibiting excellent dielectric properties and excellent electric resistivity is obtained.

In each of above described Example 1 and Comparative Examples 1 to 4, annealing was carried out under the conditions that firing was conducted in the air at 1000°C for 4 hours. Next, examples in which dielectric ceramic powders were prepared by setting the annealing conditions as follows will be described as Example 2 and Comparative Examples 5 to 8. It is to be noted that Example 2 was performed in the same manner as Example 1 except that annealing conditions were such that firing was conducted in the air at 1100°C for 4 hours. Additionally, Comparative Examples 5, 6, 7 and 8 correspond to Comparative Examples 1, 2, 3 and 4, respectively, and each was obtained in the same manner as in corresponding Comparative Example except for the annealing conditions.

Next, a resin was mixed in each of the spherical powders prepared in Example 2 and Comparative Examples 5 to 8 to yield 5 composite dielectric materials. The content of the dielectric ceramic powder in each of the composite dielectric materials was set at 50 vol%, and the polyvinyl benzyl ether compounds represented by formula (1) were used as resin.

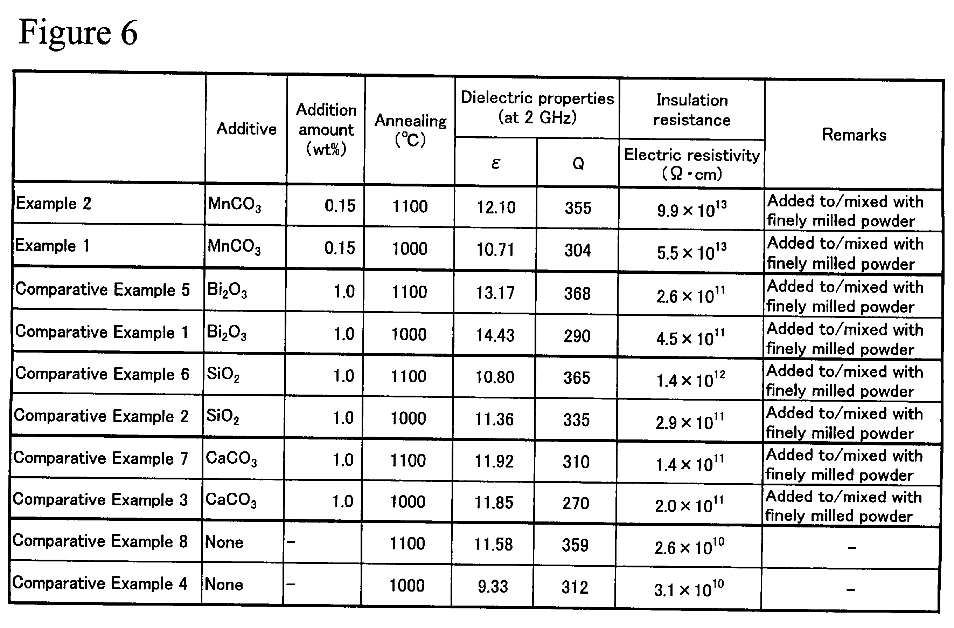

For each of the 5 composite dielectric materials, the dielectric constant ε (2 GHz) and the Q value were measured by means of the same method as described above. The results obtained are shown in Figure 6. The electric resistivities were also measured by means of the same method as described above, and the results obtained are also shown in Figure 6. For the convenience of comparison, there are shown in Figure 6 the dielectric constants ε (2 GHz), the Q values and the electric resistivities of Example 1 and Comparative Examples 1 to 4.

As shown in Figure 6, the sample added with MnCO₃ as additive (Example 2) exhibited such satisfactory dielectric properties that the dielectric constant ε at 2 GHz was 12.10 and the Q value was 355; as for the electric resistivity, there was exhibited a further higher value of 9.9 × 10¹³ Ω·cm than that of a case (Example 1) where the annealing temperature was 1000°C.

On the other hand, the sample (Comparative Example 5) added with Bi₂O₃ as additive and the sample (Comparative Example 7) added with CaCO₃ as additive exhibited electric resistivities decreased than the cases (Comparative Examples 1 and 3) with the annealing temperature of 1000°C, respectively. The sample (Comparative Example 6) added with SiO₂ as additive exhibited an electric resistivity increased than the case (Comparative Example 2) with the annealing temperature of 1000°C; however, the value concerned was such an insufficient value as 1.4 × 10¹² Ω·cm.

From the above described results, it has been found that MnCO₃ was effective as additive also in the case where the annealing temperature was set at 1100°C. In the case where MnCO₃ is used as additive, there can be obtained a composite dielectric materialexhibitingsuch a high dielectric constant ε as 12.0 or more at 2 GHz and such a Q value as 350 or more, and additionally such a satisfactory electric resistivity as 9.9 × 10¹³ Ω·cm.

### [Experimental Example 2]

An experiment carried out for checking the preferable addition amount in the case where MnCO₃ is used as additive will be described as Experimental Example 2.

Dielectric ceramic powders were prepared in which the addition amount of MnCO₃ was set at 0.025 wt%, 0.05 wt%, 0.1 wt%, 0.15 wt%, 0.2 wt%, 0.3 wt% and 1.0 wt%, respectively. Composite dielectric materials were prepared under the same conditions as in Example 1 except that the timing of the addition of MnCO₃ and the annealing conditions were set as follows. An analysis of the compositions of the dielectric ceramic powders was conducted to confirm that BaO, Nd₂O₃, TiO₂ and MnO were contained.

### <Timing of the addition of MnCO₃>

Addition was made in the mixing/drying step (step S103).

### <Annealing conditions>

Firing was conducted in the air at 1100°C for 4 hours.

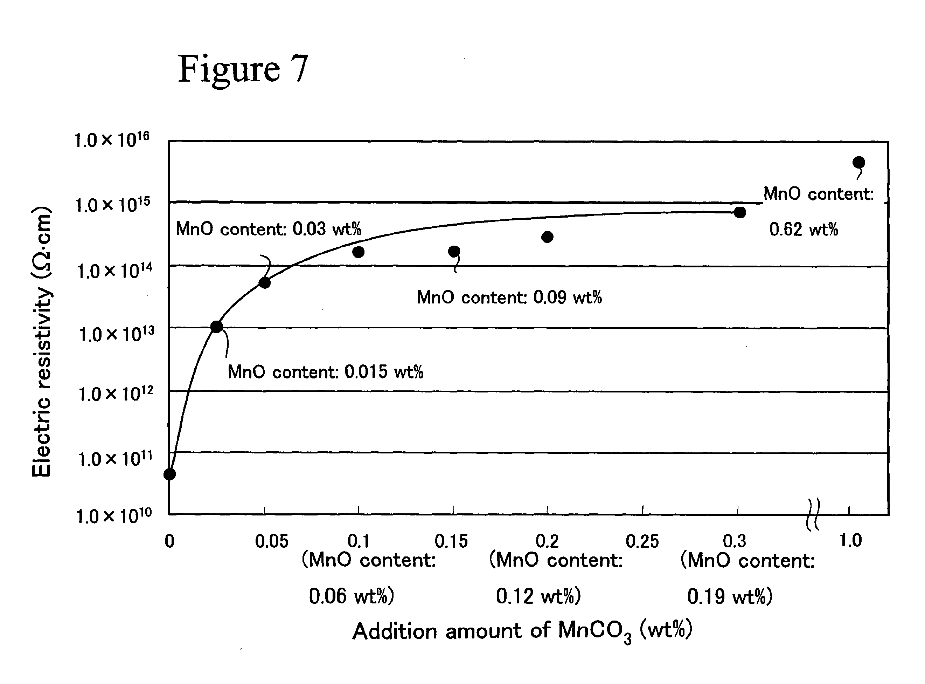

For each of the 7 composite dielectric materials, the electric resistivity was measured by means of the same method as described above. The results obtained are shown in Figure 7. For the convenience of comparison, there are also shown in Figure 7 the electric resistivities of the samples without MnCO₃ added therein.

As shown in Figure 7, addition of MnCO₃ in such a slight amount as 0.025 wt% (the content of MnO in the analysis value after firing: 0.015 wt%) improved the electric resistivity from less than 1.0 × 10¹¹ Ω·cm up to 1.0 × 10¹³ Ω·cm.

Moreover, the electric resistivity was increased with increasing addition amount of MnCO₃ in a sequence of 0.05 wt% (the content of MnO in the analysis value after firing: 0.03 wt%), 0.1 wt% (the content of MnO in the analysis value after firing: 0.06 wt%), 0.15 wt% (the content of MnO in the analysis value after firing: 0.09 wt%), and 0.2 wt% (the content of MnO in the analysis value after firing: 0.12 wt%). When the addition amount of MnCO₃ was 0.1 wt% (the content of MnO in the analysis value after firing: 0.06 wt%) ormore, the electric resitivity exhibited such a satisfactory value as 1.0 × 1.0¹⁴ Ω·cm or more.

From the above results, it has been confirmed that MnCO₃ is an additive effective in improving the electric resistivity, and the electric resistivity is increased in proportion to the addition amount of MnCO₃. The effect of the addition was remarkable even when the content of MnO in the analysis value after firing is as small as 0.015 wt%. Accordingly, it is conceivable that the effect of the improvement of the electric resistivity due to the addition of the Mn oxide can be enjoyed even when the content of the Mn oxide involved in the dielectric ceramic powder is as small as about 0.01 wt%. The added MnCO₃ (molecular weight: 114.94) was converted to MnO (molecular weight: 70.94) in the step in which the MnCO₃ was melted and spheroidized together with the other starting material powders. Accordingly, the content of MnO in the final analysis value can be derived by dividing the addition amount of MnCO₃ by 1.62.

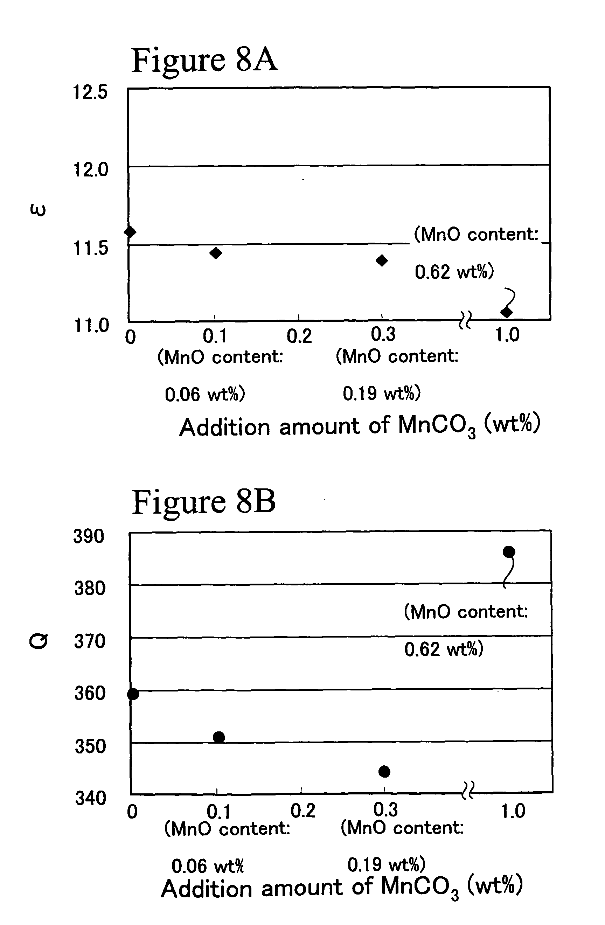

Next, for each of the composite dielectric materials using the dielectric ceramic powders for which the addition amount of MnCO₃ was respectively set at 0.1 wt%, 0.3 wt% and 1.0 wt%, the dielectric constant ε (2 GHz) and the Q value were measured by means of the same method as described above. The measured results of the dielectric constants ε (2 GHz) and the Q values are shown in Figures 8A and 8B, respectively. For the convenience of comparison, there are also shown the dielectric constant ε (2 GHz) and the Q value of a sample without MnCO₃ added therein in Figures 8A and 8B, respectively.

First, as can be seen from Figure 8A, with increasing addition amount of MnCO₃, the dielectric constant ε decreased slowly; the dielectric constant ε decreased down to about 11 when the addition amount of MnCO₃ was 1.0 wt% (the content of MnO in the analysis value after firing: 0.62 wt%). Consequently, it is conceivably effective that the addition amount of MnCO₃ is set at 0.3 wt% (the content of MnO in the analysis value after firing: 0. 19 wt%) or less for the purpose of obtaining a dielectric constant ε of 11.2 or more, and moreover, about 11.5.

Second, as can be seen from Figure 8B, with increasing addition amount of MnCO₃, the Q value decreased slowly; the Q value decreased by about 15 than that in the case without added MnCO₃ when the addition amount of MnCO₃ was 0.3 wt% (the content of MnO in the analysis value after firing: 0.19 wt%).

From the above described results, for the purpose of simultaneously obtaining a high dielectric constant ε and a high Q value, it has been found effective that the addition amount of MnCO₃ is set at 0.3 wt% (the content of MnO in the analysis value after firing: 0.19 wt%) or less, and furthermore, in a range from 0.01 to 0.2 wt% (the content of MnO in the analysis value after firing: 0.006 to 0.12 wt%). By setting the addition amount of MnCO₃ in the range from 0.01 to 0.2 wt% (the content of MnO in the analysis value after firing: 0.006 to 0.12 wt%), there can be obtained a dielectric constant ε of 11.2 or more and a Q value of 345 or more.

From the above described results, for the purpose of increasing the electric resistivity while high dielectric properties are being maintained, it is preferable that the addition amount of MnCO₃ is set at 0.3 wt% or less, namely, the content of MnO in the final analysis is set at 0.19 wt% or less. The more preferable content of MnO is 0.12 wt% or less (exclusive of 0), and the furthermore preferable content of MnO is 0.01 to 0.1 wt%.

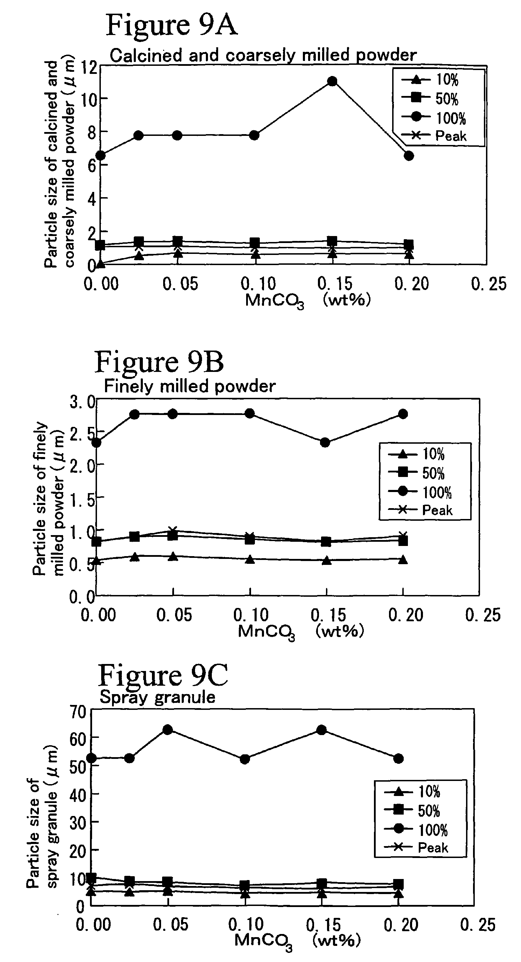

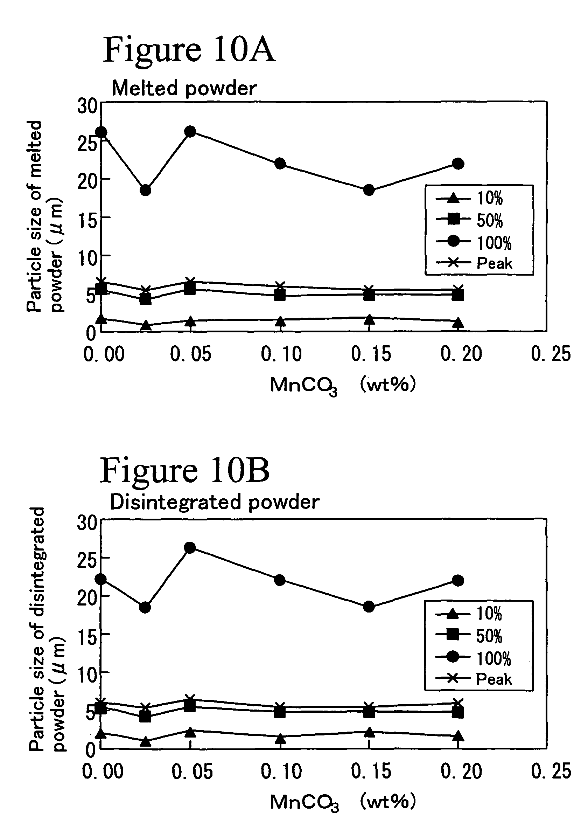

Here, Figures 9 and 10 show the observed results of the particle size distribution in each of the steps involved in preparation of a spherical powder. Figure 9A shows the particle size distributions of calcined and coarsely milled powders after the calcining step (step S105) shown in Figure 1; Figure 9B shows the particle size distributions of finely milled powders after the finely milling step (step S107) shown in Figure 1; and Figure 9C shows the particle size distributions of spray granular powders prepared in the granulating/spheroidizing step (step S111) shown in Figure 1. Figure 10A shows the particle size distributions of fused powders fused in the granulating/spheroidizing step (step S111) shown in Figure 1; and Figure 10B shows the particle size distributions of disintegrated powders after the aggregate disintegrating step (step S115). It is to be noted that "10%" in Figures 9 and 10 means the 10% particle size. Here, the 10% particle size means the particle size at which a cumulative curve reaches 10% where the cumulative curve is obtained by representing the total volume of the measured powder as 100%. Similarly, in Figures 9 and 10, "50%" and "100%" mean the 50% particle size and the 100% particle size, respectively, indicating the particle sizes at which the cumulative curve reaches 50% and 100%, respectively. Also in Figures 9 and 10, "peak" means the peak value of a cumulative curve.

As can be seen from Figures 9 and 10, the particle size in the case where no MnCO₃ was added and the particle size in the case where MnCO₃ was added in a content of 0.20 wt% approximately coincide with each other in any of the calcined and coarselymilled powder, the finelymilled powder, the spray granular powder, the fused powder and the disintegrated powder. It has also been confirmed that the 10% particle size, the 50% particle size and the peak value in the particle size distribution exhibited little variations even when the addition amount of MnCO₃ was increased.

From the above described results, it can be said that addition of MnCO₃ little affects the particle size distribution.

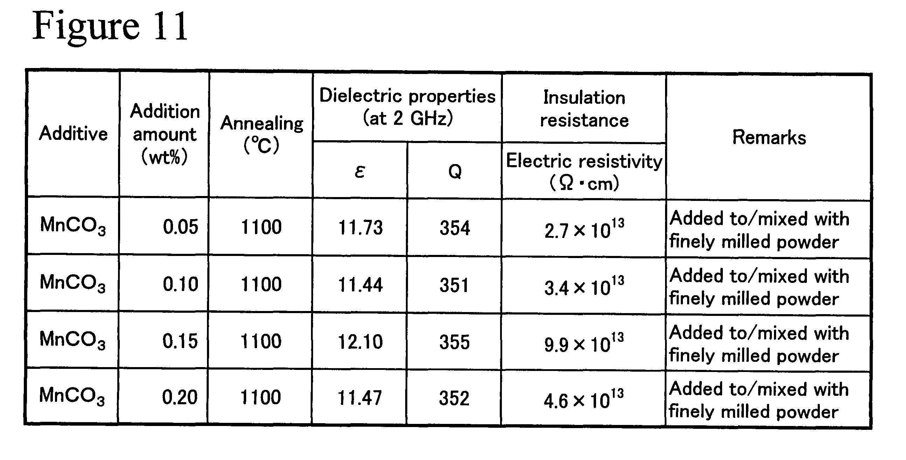

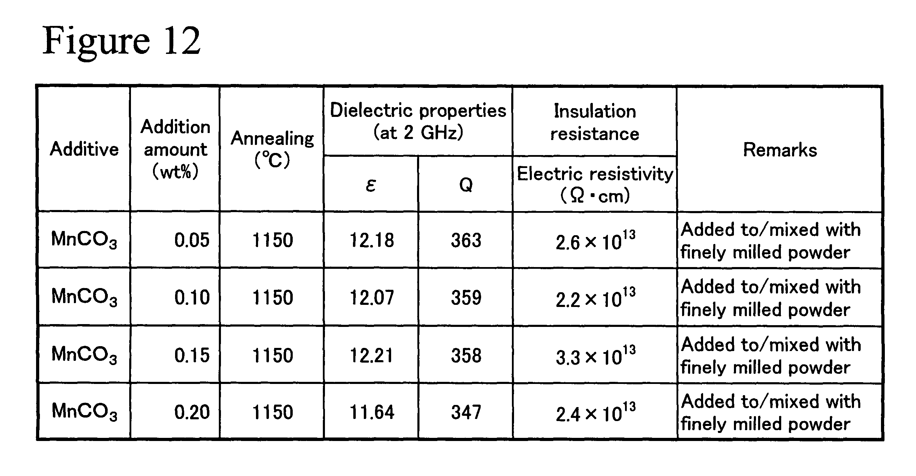

In the above, description has been made on the properties in the cases where MnCO₃ was added in the mixing/drying step (step S103). Next, Figures 11 and 12 show the dielectric property variation and the electric resistivity variation each as a function of the addition amount of MnCO₃ in the cases where MnCO₃ was mixed in the finely milling step (step S107) in the same manner as in Example 1. Figure 11 shows the properties of the samples obtained under the annealing conditions of maintenance at 1100°C for 4 hours, while Figure 12 shows the properties of the samples obtained under the annealing conditions of maintenance at 1150°C for 4 hours.

As can be seen from Figures 11 and 12, in any of the cases where the annealing temperature was 1100°C and 1150°C, respectively, there were exhibited satisfactory dielectric properties, and specifically, dielectric constants ε of 10 or more and Q values of 300 or more in such a high frequency band as 2 GHz.

The electric resistivity also exhibited such high values as 2.0 × 10¹³ Ω·cm or more in any of the cases where the annealing temperature was 1100°C and 1150°C, respectively. In Figure 7 described above, no peak was observed in the variation of the electric resistivity as a function of the addition amount of MnCO₃. However, as can be seen from any of Figures 11 and 12, the highest electric resistivity was exhibited when the addition amount of MnCO₃ was 0.15 wt% (the content of MnO in the final analysis value: 0.09 wt%). Accordingly, when MnCO₃ is mixed in the finely milling step (step S107), it can be said that MnCO₃ is added preferably in such a way that the content of MnO in a dielectric ceramic powder is 0.05 to 0.25 wt%, and moreover, 0.01 to 0.02 wt%. When the properties of the samples shown in Figure 11 are compared with the properties of the samples shown in Figure 12, the samples shown in Figure 11 show higher electric resistivities, and hence it is effective to set the annealing temperature at 1100°C for the purpose of improving the electric resistivity through inclusion of MnO.

### [Experimental Example 3]

An experiment carried out for checking the relation between the specific surface area of the dielectric ceramic powder and the resistivity will be described as Experimental Example 3.

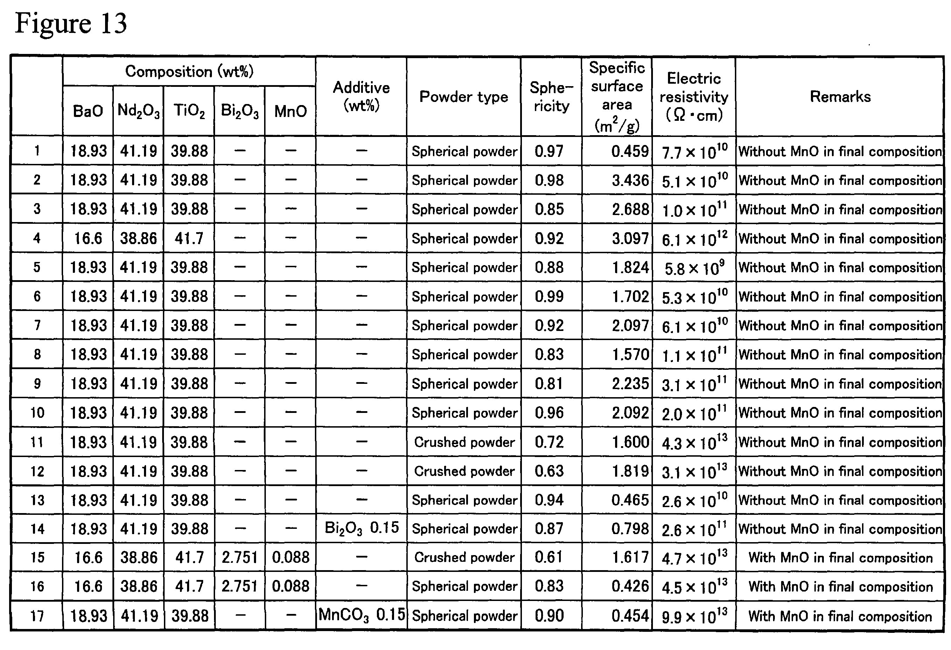

The starting material powders were blended so as to give the compositions shown in Figure 13 to prepare 17 dielectric ceramic powders. Then, a resin was mixed in each of the dielectric ceramic powders to yield 17 composite dielectric materials. It is to be noted that for Sample No. 14 and Sample No. 17 shown in Figure 13, MnCO₃ and Bi₂O₃ were added after milling, respectively.

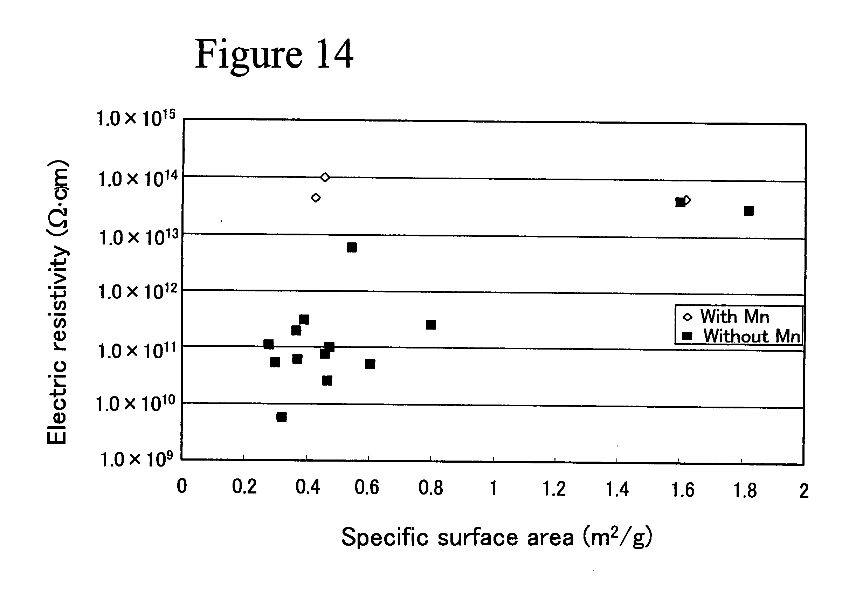

The electric resistivities of the composite dielectric materials thus obtained were measured. Figure 14 shows the relation between specific surface area and the electric resistivity.

As shown in Figure 14, for the samples which did not contain MnO after firing (the samples indicated as "without Mn" in Figure 14), it was found that the electric resistivity tended to decrease with decreasing specific surface area. On the contrary, for the samples which contained MnO after firing (the samples indicated as "with Mn" in Figure 14), the electric resistivity exhibited such high values as 1.0 × 10¹³ Ω·cm irrespective of the specific surface area.

Accordingly, it has been found that when a composite dielectric material is produced by using a dielectric ceramic powder having such a small specific surface area as 1.2 m²/g, the decrease of the electric resistivity can be suppressed by making the dielectric ceramic powder contain MnO.

### [Experimental Example 4]

An experiment carried out for checking the properties of a substrate produced by use of the composite dielectric material of the present invention is shown as Experimental Example 4.

A spherical dielectric ceramic powder was produced by the same procedures as in Experimental Example 1 except that weighing was carried out so as for the final composition to contain 16.596 wt% of BaO, 38.863 wt% of Nd₂O₃, 41.702 wt% of TiO₂, 2.751 wt% of Bi₂O₃ and 0.088 wt% of MnO. The mean particle size of the obtained powder was 5 µm.

Additionally, as Comparative Example, a dielectric material having the above described composition was milled by use of a ball mill to yield a crushed powder (a dielectric ceramic powder) having a mean particle size of 2 µm.

Then, a resin was mixed in each of the spherical powder and the milled powder to yield composite dielectric materials. In any of the spherical powder and the crushed powder, the content of the dielectric ceramic powder in the composite dielectric material was made to be 50 vol%, and a polyvinyl benzyl ether compound represented by formula (1) was used as resin.

For the purpose of comparing the fluidity of the composite dielectric material (hereinafter referred to as Sample 1) using the spherical powder and the fluidity of the composite dielectric material (hereinafter referred to as Sample 2) using the crushed powder, patterns were formed on bases formed of glass epoxy resin, Sample 1 and Sample 2 were applied onto the bases, respectively, and subjected to press molding under the conditions described below to yield substrates.

### Press molding conditions:

Pressure: 40 kgf/cm²
Temperature: the temperature was increased from room temperature up to 150°C and maintained at that temperature for 30 minutes. Subsequently, the temperature was increased up to 195°C, and maintained at that temperature for 3 hours.

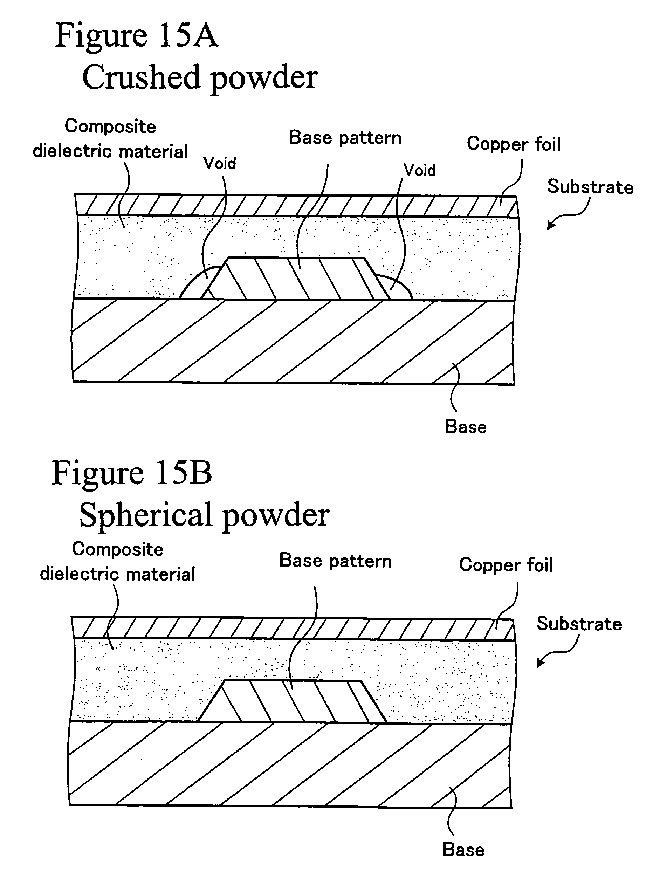

The sections of the substrates thus produced were observed by use of a microscope. The results obtained are schematically shown in Figure 15.

As shown in Figure 15A, voids were observed near the pattern edges in the substrate produced by use of Sample 2. On the contrary, as shown in Figure 15B, when Sample 1, namely, the spherical powder was used, the spherical particles were filled in near the pattern edges. From the above results, it has been found that the composite dielectric material using the spherical powder involved in the present invention is satisfactory in fluidity.

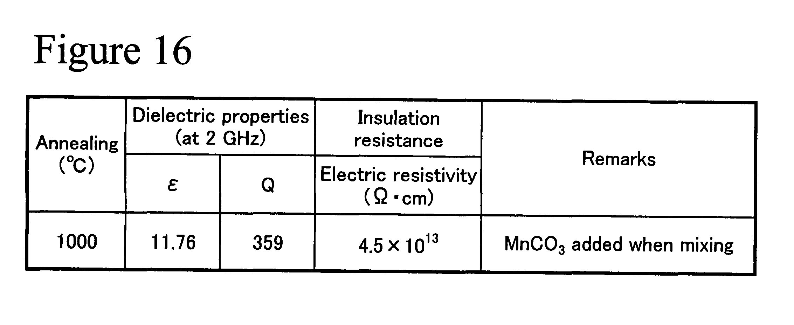

Then, for the substrate produced by use of the composite dielectric material of the present invention, the dielectric constant thereof ε (2 GHz) was measured by means of the cavity resonator method (a perturbation method) (83260A and 8757C manufactured by Hewlett Packard, Inc. were used). The Q value was also measured. The results obtained are shown in Figure 16. The electric resistivity of the substrate was also measured by means of the same method as described above. The result obtained is also shown in Figure 16.

As shown in Figure 16, the substrate produced by use of the composite dielectric material of the present invention exhibited such a high electric resistivity as 4.5 × 10¹³ Ω·cm. Moreover, this substrate exhibited such a dielectric constant ε as 11 or more and such a Q value as 350 or more, thus showing satisfactory dielectric properties.

### Industrial Applicability

As described above in detail, according to the present invention, there can be obtained a composite dielectric material simultaneously having a high dielectric constant ε and a high Q value, and a high electric resistivity. Additionally, according to the present invention, there can be obtained a composite dielectric material having satisfactory dielectric properties and a satisfactory electric resistivity, being excellent in moldability and machinability,and easily applicable to downsized appliances, and a substrate using the composite dielectric material.

## Claims

1. A composite dielectric material comprising a resin material and an approximately spherical dielectric ceramic powder to be mixed with said resin material, the composite dielectric material being **characterized in that**:
said dielectric ceramic powder is based on BaO-R₂O₃-TiO₂ (R: a rare earth element, R₂O₃: an oxide of the rare earth element); and
said dielectric ceramic powder comprises an oxide of a transition metal element having at least two states of ionic valences less than 4.

2. A composite dielectric material comprising a resin material and a dielectric ceramic powder to be mixed with said resin material, the composite dielectric material being **characterized in that**:
said dielectric ceramic powder is based on BaO-R₂O₃-TiO₂ (R: a rare earth element, R₂O₃: an oxide of the rare earth element) and the sphericity thereof is 0.8 to 1; and
said dielectric ceramic powder comprises an oxide of a transition metal element having at least two states of ionic valences less than 4.

3. The composite dielectric material according to claim 1 or 2, **characterized in that** said transition metal element is Mn or Cr.

4. The composite dielectric material according to claim 1 or 2, **characterized in that** the sphericity of said dielectric ceramic powder is 0.85 to 1.

5. The composite dielectric material according to claim 1 or 2, **characterized in that** said dielectric ceramic powder has a composition that BaO: 6.67 to 21.67 mol%, R₂O₃: 6.67 to 26.67 mol%, and TiO₂: 61.66 to 76.66 mol%.

6. A composite dielectric material comprising a resin material and a dielectric ceramic powder to be mixed with said resin material, the composite dielectric material being **characterized in that**:
said dielectric ceramic powder comprises one or more of a Mn oxide, a Cr oxide, a Fe oxide, a Co oxide, a Ni oxide and a Cu oxide, and has a specific surface area of 1.2 m²/g or less (exclusive of 0).

7. The composite dielectric material according to claim 6, **characterized in that** said dielectric ceramic powder comprises said Mn oxide and the content of said Mn oxide in said composite dielectric material is 0.12 wt% or less (exclusive of 0) in terms of MnO.

8. The composite dielectric material according to claim 6, **characterized in that** said dielectric ceramic powder comprises said Mn oxide and the content of said Mn oxide in said composite dielectric material is 0.01 to 0.1 wt% in terms of MnO.

9. The composite dielectric material according to claim 6, **characterized in that** the sphericity of the particles of said dielectric ceramic powder is 0.8 to 1.

10. The composite dielectric material according to any one of claims 1, 2 and 6, **characterized in that** the mean particle size of said dielectric ceramic powder is 0.5 to 10 µm.

11. The composite dielectric material according to any one of claims 1, 2 and 6, **characterized in that** the dielectric constant ε thereof is 10 or more (measurement frequency: 2 GHz) and the Q value thereof is 300 or more (measurement frequency: 2 GHz).

12. The composite dielectric material according to any one of claims 1, 2 and 6, **characterized in that** the electric resistivity of said composite dielectric material is 1.0 × 10¹² Ω·cm or more.

13. The composite dielectric material according to any one of claims 1, 2 and 6, **characterized in that** the content of said dielectric ceramic powder is 40 vol% or more and 70 vol% or less when the total content of said resin material and said dielectric ceramic powder is represented as 100 vol%.

14. The composite dielectric material according to any one of claims 1, 2 and 6, **characterized in that** said resin material is a polyvinyl benzyl ether compound.

15. A substrate comprising a mixture composed of a resin material and a dielectric ceramic powder, the substrate being
**characterized in that**:
said dielectric ceramic powder is approximately spherical;
the content of said dielectric ceramic powder is 40 vol% or more and 70 vol% or less when the total content of said resin material and said dielectric ceramic powder is represented as 100 vol%; and
the electric resistivity of said substrate is 1.0 × 10¹² Ω·cm or more.

16. A substrate comprising a base having projections on the surface thereof and a composite dielectric material coating said base having said projections formed thereon, the substrate being **characterized in that**:
said composite dielectric material comprises:
a resin material; and
a dielectric ceramic powder to be mixed with said resin material, the powder comprising a Mn oxide and being approximately spherical.

17. A substrate comprising a mixture composed of a resin material and a dielectric ceramic powder, the substrate being **characterized in that**:
the sphericity of said dielectric ceramic powder is 0.8 to 1;
the content of said dielectric ceramic powder is 40 vol% or more and 70 vol% or less when the total content of said resin material and said dielectric ceramic powder is represented as 100 vol%; and
the electric resistivity of said substrate is 1.0 × 10¹² Ω·cm or more.

18. A substrate comprising a base having projections on the surface thereof and a composite dielectric material coating said base having saidprojections formed thereon, the substrate being **characterized in that**:
said composite dielectric material comprises:
a resin material; and
a dielectric ceramic powder to be mixed with said resin material, the powder comprising a Mn oxide and the sphericity of the particles of the powder being 0.8 to 1.

19. The substrate according to any one of claims 15 to 18, **characterized in that** the dielectric constant ε thereof is 10 or more (measurement frequency: 2 GHz) and the Q value thereof is 300 or more (measurement frequency: 2 GHz).

20. The substrate according to any one of claims 15 to 18, **characterized in that** said substrate is used as electronic parts.
